# EUROPEAN PATENT APPLICATION

(11) **EP 4 852 638 A1**
(43) Date of publication of application: **09.12.2026**
(21) Application number: 26182370.2
(22) Date of filing: 01.06.2026
(51) Int. Cl.: H05K 7/20

(54) **BUFFER TANK WITH PHASE CHANGE MATERIAL FOR LIQUID COOLING APPLICATIONS**

(30) Priority: 02.06.2025 US 202563816569 P; 06.05.2026 US 202619668816
(71) Applicant: Vertiv Corporation, Westerville, OH 43082 (US)
(72) Inventor: TAKACS, Balint, Westerville, 43082 (US); BARBATO, Pierpaolo, Westerville, 43082 (US); VOIGT, Tyler William, Westerville, 43082 (US)
(74) Representative: Kilburn & Strode LLP

(57) **Abstract**

A cooling system can include a primary loop for circulating a primary cooling fluid, a secondary loop for circulating a secondary cooling fluid, a fluid-to-fluid heat exchanger fluidically coupled to the primary loop and/or the secondary loop, and a buffer tank fluidically coupled to the primary loop and/or the secondary loop. The fluid-to-fluid heat exchanger can be fluidically coupled in parallel with the buffer tank with respect to the secondary cooling fluid and/or fluidically coupled in series with the buffer tank with respect to the primary cooling fluid. The buffer tank can selectively absorb heat from the primary loop and/or transfer heat to the secondary loop.

## Description

### CROSS-REFERENCE TO RELATED APPLICATION(S)

This application claims the benefit of U.S. Provisional Patent Application No. 63/816,569 filed June 2, 2025.

### TECHNICAL FIELD

The present disclosure relates generally to cooling systems, such as those used in data centers, and more specifically relates to accommodating surges and/or power outages in such systems.

### BACKGROUND

Data center operators and designers desire sufficient and efficient cooling. However, data centers can experience sudden changes in cooling demand and/or power outages. Many cooling systems cannot adequately handle large fluctuations in cooling demand, which can occur during startup and/or during relatively normal operations, or span power outages before a backup generator can be brought online.

### SUMMARY

Applicant has created new and useful devices, systems and methods for accommodating cooling demand surges and/or power outages in cooling systems, such as those used in data centers. In at least one embodiment, a cooling system according to the disclosure can advantageously utilize a buffer tank to accommodate large fluctuations in cooling demand and/or to provide cooling during a power outage, such as during the time between when utility power is lost and a backup generator is brought online. In at least one embodiment, media within the buffer tank can be cooled during normal operations and can absorb heat when needed, which can advantageously provide for accommodation of cooling demand fluctuations, cooling during temporary power loss, and/or increased cooling capacity within a given cooling system space. In at least one embodiment, a cooling system according to the disclosure can provide more cooling capacity in the same space versus a conventional system and/or can provide at least the same cooling capacity while occupying less space.

In at least one embodiment, a cooling system according to the disclosure can include a primary loop for circulating a primary cooling fluid, a secondary loop for circulating a secondary cooling fluid, a fluid-to-fluid heat exchanger fluidically coupled to the primary loop and/or the secondary loop, a buffer tank fluidically coupled to the primary loop and/or the secondary loop, or any combination thereof. In at least one embodiment, the primary loop can extract heat from a heat load using the primary cooling fluid. In at least one embodiment, the secondary loop can reject the heat from the heat load using the secondary cooling fluid. In at least one embodiment, the fluid-to-fluid heat exchanger can transfer the heat from the primary cooling fluid to the secondary cooling fluid. In at least one embodiment, the buffer tank can selectively absorb heat from the primary loop and/or transfer heat to the secondary loop. In at least one embodiment, the fluid-to-fluid heat exchanger can be fluidically coupled in parallel with the buffer tank with respect to the secondary cooling fluid. In at least one embodiment, the fluid-to-fluid heat exchanger can be fluidically coupled in series with the buffer tank with respect to the primary cooling fluid.

In at least one embodiment, the buffer tank can be plumbed in parallel with a control valve in the primary loop. In at least one embodiment, an inlet valve can be fluidically coupled between the heat load and the buffer tank. In at least one embodiment, an outlet valve can be fluidically coupled between the buffer tank and the fluid-to-fluid heat exchanger. In at least one embodiment, the inlet valve and/or the outlet valve can control flow of the primary cooling fluid through the buffer tank.

In at least one embodiment, the cooling system according to the disclosure can include a controller for monitoring a temperature of the primary cooling fluid exiting the heat load and/or selectively directing, such as according to the temperature, a portion of the primary cooling fluid through the buffer tank using the control valve, the inlet valve, the outlet valve, or any combination thereof. In at least one embodiment, the controller can selectively prevent flow of the primary cooling fluid through the buffer tank, such as to allow the fluid-to-fluid heat exchanger to transfer the heat to the secondary cooling fluid, and/or selectively permit flow of the primary cooling fluid through the buffer tank, such as to absorb heat from the primary loop and/or primary cooling fluid. In at least one embodiment, the controller can open and/or close the inlet valve and the outlet valve together. In at least one embodiment, the controller can open and/or close the inlet valve and/or the outlet valve inversely proportionally to the control valve.

In at least one embodiment, the cooling system according to the disclosure can include an inlet valve fluidically coupled between the secondary loop and the buffer tank and/or an outlet valve fluidically coupled between the buffer tank and the secondary loop. In at least one embodiment, the inlet valve and/or the outlet valve can control flow of the secondary cooling fluid through the buffer tank. In at least one embodiment, the cooling system according to the disclosure can include a controller (which can be the same controller or a different controller as the one discussed above) for monitoring a temperature of the secondary cooling fluid exiting the buffer tank and/or controlling a flow rate of the secondary cooling fluid through the buffer tank using the inlet valve and the outlet valve. In at least one embodiment, the controller can maintain the flow rate of the secondary cooling fluid through the buffer tank above zero and/or prevent the flow rate from dropping to zero, such as to continuously monitor the temperature of the secondary cooling fluid exiting the buffer tank and/or a temperature (or temperature approximation/surrogate) of one or more contents of the buffer tank.

In at least one embodiment, the buffer tank can contain a phase change media, such as wax, glycerin, another phase change media, or any combination thereof. In at least one embodiment, the media can be different than the primary cooling fluid and/or the secondary cooling fluid, either or both of which can be or include water, a water-glycol mixture, a refrigerant, another cooling fluid, or any combination thereof. In at least one embodiment, the buffer tank can contain the media therein while the primary cooling fluid and/or the secondary cooling fluid pass through the buffer tank. In at least one embodiment, the buffer tank can be arranged to prevent the media from mixing with the primary cooling fluid and/or the secondary cooling fluid as they pass through the buffer tank. In at least one embodiment, the media can remain fluidically isolated from, yet be thermally coupled to, the primary cooling fluid and/or the secondary cooling fluid.

In at least one embodiment, the phase change media in the buffer tank can change from a solid phase to a liquid phase while absorbing heat from the primary cooling fluid and/or change from a liquid phase to a solid phase while transferring heat to the secondary cooling fluid. In at least one embodiment, volumetric and/or pressure changes of the phase change media, in transitioning between the solid phase and the liquid phase, can be negligible. In at least one embodiment, pressure and/or other forces exerted on the buffer tank by the phase change media, in transitioning between the solid phase and the liquid phase, can be negligible.

In at least one embodiment, a method of operating a cooling system according to the disclosure can include extracting heat from a heat load, such as by circulating a primary cooling fluid through the heat load, transferring heat from the primary cooling fluid to a secondary cooling fluid, rejecting heat from the secondary cooling fluid, monitoring a temperature of the primary cooling fluid exiting the heat load, absorbing a portion of the heat within a phase change media, such as when the temperature exceeds a threshold, cooling the phase change media by circulating a secondary cooling fluid through the buffer tank, or any combination thereof. In at least one embodiment, absorbing a portion of the heat within a phase change media can include directing a portion of the primary cooling fluid through a buffer tank containing the phase change media. In at least one embodiment, transferring the heat from the primary cooling fluid to the secondary cooling fluid can be done via a fluid-to-fluid heat exchanger fluidically coupled in parallel with the buffer tank with respect to the secondary cooling fluid and/or fluidically coupled in series with the buffer tank with respect to the primary cooling fluid.

### BRIEF DESCRIPTION OF THE DRAWINGS

FIG. 1 is a schematic view of one of many embodiments of a cooling system according to the disclosure.
FIG. 2 is a cross sectional schematic view of one of many embodiments of a buffer tank according to the disclosure.
FIG. 3 is a graph illustrating one of many examples of a proportional control logic according to the disclosure, showing valve opening percentage as a function of cooling media temperature leaving the buffer tank.
FIG. 4 is a graph illustrating one of many examples of a control scheme for controlling flow through a buffer tank according to the disclosure, showing valve opening and closing percentages as a function of cooling media temperature leaving the heat source.
FIG. 5 is a flow chart illustrating one of many embodiments of a method of operating a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with systemrelated, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for accommodating cooling demand surges and/or power outages in cooling systems, such as those used in data centers. In at least one embodiment, a cooling system according to the disclosure can advantageously utilize a buffer tank to accommodate large fluctuations in cooling demand and/or to provide cooling during a power outage, such as during the time between when utility power is lost and a backup generator is brought online. In at least one embodiment, media within the buffer tank can be cooled during normal operations and can absorb heat when needed, which can advantageously provide for accommodation of cooling demand fluctuations, cooling during temporary power loss, and/or increased cooling capacity within a given cooling system space. In at least one embodiment, a cooling system according to the disclosure can provide more cooling capacity in the same space versus a conventional system and/or can provide at least the same cooling capacity while occupying less space.

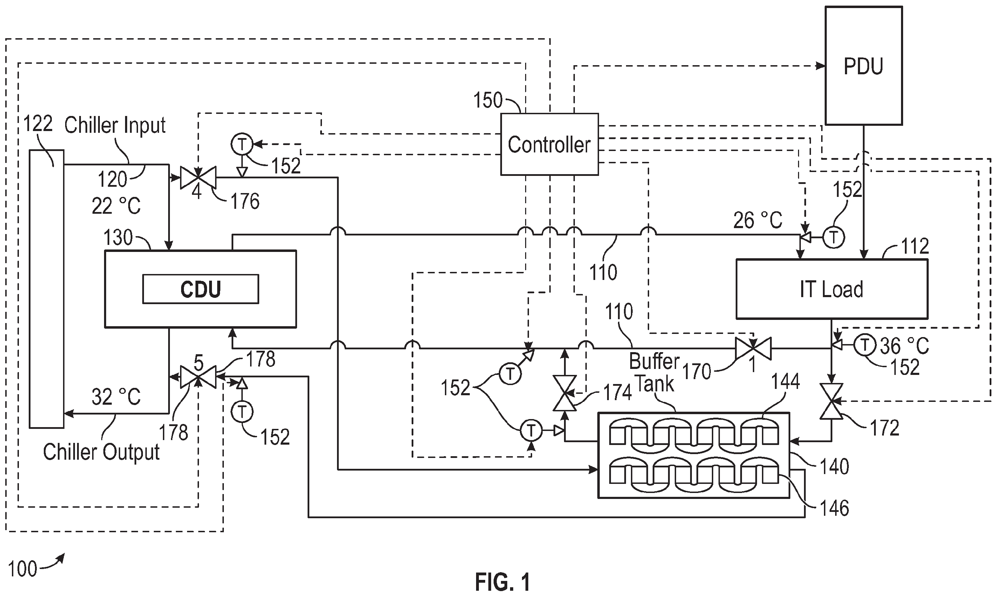

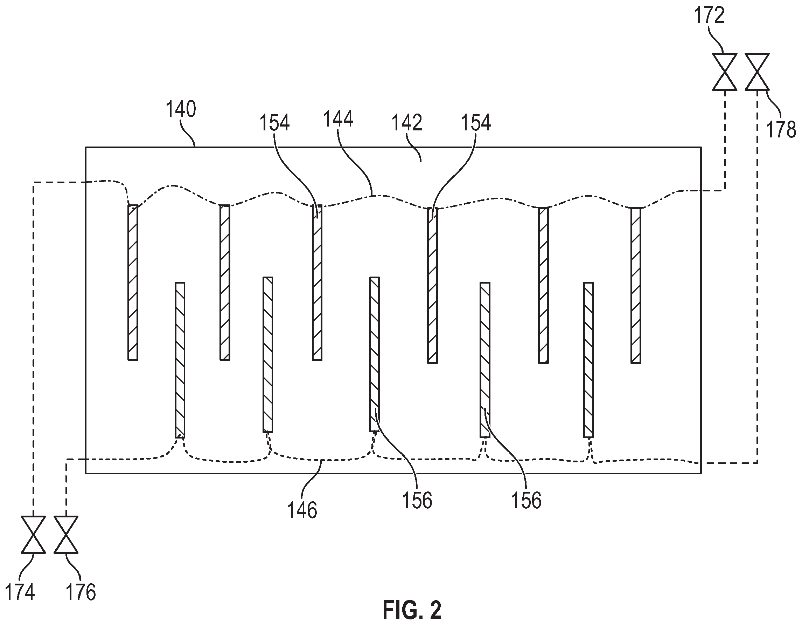

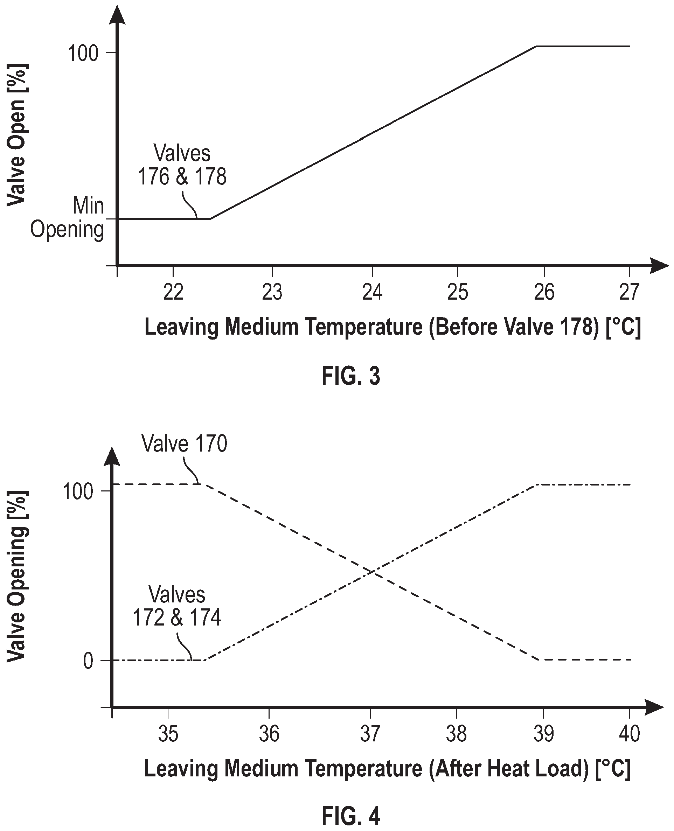

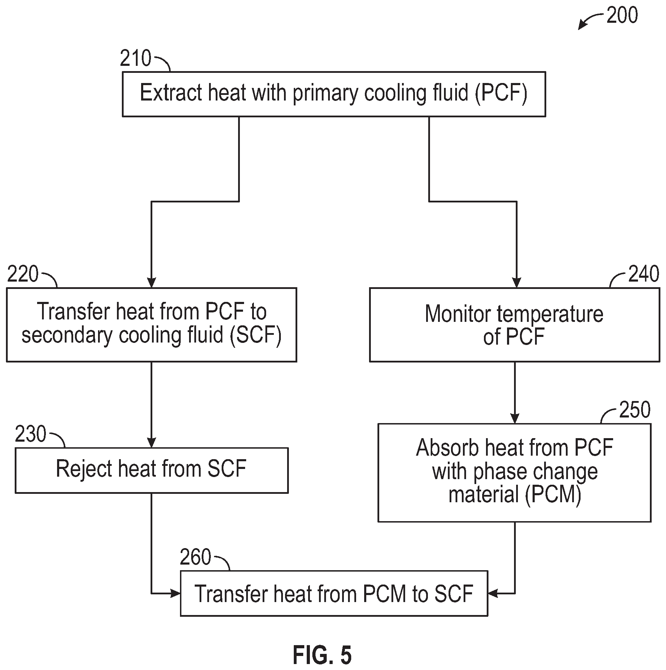

FIG. 1 is a schematic view of one of many embodiments of a cooling system according to the disclosure. FIG. 2 is a cross sectional schematic view of one of many embodiments of a buffer tank according to the disclosure. FIG. 3 is a graph illustrating one of many examples of a proportional control logic according to the disclosure, showing valve opening percentage as a function of cooling media temperature leaving the buffer tank. FIG. 4 is a graph illustrating one of many examples of a control scheme for controlling flow through a buffer tank according to the disclosure, showing valve opening and closing percentages as a function of cooling media temperature leaving the heat source. FIG. 5 is a flow chart illustrating one of many embodiments of a method of operating a cooling system according to the disclosure. FIGS. 1-5 are described in conjunction with one another.

In at least one embodiment, a cooling system 100 according to the disclosure can include one or more primary loops 110 for circulating one or more primary cooling fluids, one or more secondary loops 120 for circulating one or more secondary cooling fluids, one or more fluid-to-fluid heat exchangers 130 fluidically coupled to the primary loop(s) 110 and/or the secondary loop(s) 120, and one or more buffer tanks 140 fluidically coupled to the primary loop(s) 110 and/or the secondary loop(s) 120. In at least one embodiment, the cooling system 100 can include one or more pumps, one or more compressors, one or more controllers 150, one or more sensors 152, one or more control valves, other plumbing components, or any combination thereof, for circulating one or more cooling fluids and otherwise accomplishing one or more functions according to the disclosure.

In at least one embodiment, one or more controllers 150 can monitor any of one or more sensors 152 and/or can control any of various other system components, such as pumps, compressors, control valves, etc. In at least one embodiment, the one or more controllers 150 can be or include a single controller 150 arranged for accomplishing all or a portion of the functionality described herein. In at least one embodiment, the one or more controllers 150 can be or include multiple controllers 150, with each controller 150 accomplishing a portion of the functionality described herein.

In at least one embodiment, the primary loop 110 can extract heat from a heat load 112, such as via a primary cooling fluid circulated in thermal communication with the heat load 112. In at least one embodiment, the heat load 112 can be or include one or more individual servers, one or more server cabinets, computing equipment, networking equipment, power equipment, other heat generating equipment, or any combination thereof. In at least one embodiment, the primary loop 110 can include one or more heat exchangers (not shown) thermally coupled with and/or within the heat load 112 to extract heat therefrom. In at least one embodiment, such heat exchangers can be or include one or more direct-to-chip cold plates, one or more other cold plates, one or more air-to-fluid heat exchangers, one or more evaporators, or any combination thereof.

In at least one embodiment, the primary cooling fluid can be a single-phase fluid, such as water or a water-glycol mixture, and can be driven by a pump. In at least one embodiment, the primary cooling fluid can be a two-phase fluid, such as a refrigerant, and can be driven by a compressor. In at least one embodiment, the secondary loop 120 can reject heat from the heat load 112, such as via the secondary cooling fluid. In at least one embodiment, the secondary loop 120 can reject heat through one or more rejection heat exchangers 122, such as one or more chillers, one or more cooling towers, one or more dry coolers, one or more condensers, one or more other heat exchangers, or any combination thereof. In at least one embodiment, the secondary cooling fluid can be or include a single-phase fluid, or a two-phase fluid.

In at least one embodiment, the fluid-to-fluid heat exchanger 130, such as a coolant distribution unit (CDU) or other fluid-to-fluid heat exchanger, can transfer heat from the primary cooling fluid to the secondary cooling fluid. In at least one embodiment, the fluid-to-fluid heat exchanger 130 can be or include one or more brazed plate heat exchangers and/or other heat exchangers. In at least one embodiment, the fluid-to-fluid heat exchanger 130 can have a rated heat transfer capacity for a given operating temperature or range of operating temperatures. For instance, in at least one embodiment, which is but one of many, the controller 150 can control one or more pumps, compressors, control valves, and/or other system components to provide a primary cooling fluid to the heat load 112 at approximately 26 degrees Celsius, given a return temperature of approximately 36 degrees Celsius.

In at least one embodiment, the system 100 can be arranged for the buffer tank 140 to selectively absorb heat from the primary loop 110 and/or to selectively transfer heat to the secondary loop 120, such as by way of the controller 150 controlling one or more valves to route one or more of the cooling fluids accordingly. In at least one embodiment, the buffer tank 140 can selectively absorb heat from the primary cooling fluid and/or selectively transfer heat to the secondary cooling fluid. In at least one embodiment, the buffer tank 140 can selectively absorb heat from the primary cooling fluid, such as for providing cooling capacity during cooling demand fluctuations and/or power outages. In at least one embodiment, the fluid-to-fluid heat exchanger 130 can be fluidically coupled in series with the buffer tank 140 with respect to the primary cooling fluid. In at least one embodiment, the fluid-to-fluid heat exchanger 130 can be fluidically coupled in parallel with the buffer tank 140 with respect to the secondary cooling fluid. In at least one embodiment, the buffer tank 140 can be fluidically coupled in parallel with the rejection heat exchanger 122, with respect to the secondary cooling fluid, and in series with the heat load 112, with respect to the primary cooling fluid.

In at least one embodiment, the buffer tank 140 can be fluidically coupled in parallel with a portion of the primary loop 110 and/or in series with a portion of the primary loop 110. In at least one embodiment, the buffer tank 140 can be plumbed in parallel with a control valve 170 in the primary loop 110. In at least one embodiment, an inlet valve 172 can be fluidically coupled between the heat load 112 and the buffer tank 140. In at least one embodiment, an inlet valve 172 can be fluidically coupled between the control valve 170 and the buffer tank 140. In at least one embodiment, an inlet valve 172 can be fluidically coupled between a portion of the primary loop 110 and the buffer tank 140. In at least one embodiment, an outlet valve 174 can be fluidically coupled between the buffer tank 140 and the fluid-to-fluid heat exchanger 130. In at least one embodiment, an outlet valve 174 can be fluidically coupled between the buffer tank 140 and the control valve 170. In at least one embodiment, an outlet valve 174 can be fluidically coupled between the buffer tank 140 and a portion of the primary loop 110. In at least one embodiment, the control valve 170, the inlet valve 172, the outlet valve 174, or any combination thereof, can control flow of the primary cooling fluid through the buffer tank 140, and/or can be controlled by one or more controllers 150.

In at least one embodiment, the controller 150 can monitor a temperature of the primary cooling fluid exiting the heat load 112, or a return temperature. In at least one embodiment, the controller 150 can detect an elevated return temperature, a cooling demand that exceeds a rated heat transfer capacity of the fluid-to-fluid heat exchanger 130, a power outage, or any combination thereof, and can direct or divert all or a portion of the primary cooling fluid to the buffer tank 140. In at least one embodiment, the controller 150 can selectively direct, such as according to the temperature and/or a power outage, a portion of the primary cooling fluid through the buffer tank 140, such as using the control valve 170, the inlet valve 172, the outlet valve 174, or any combination thereof.

In at least one embodiment, the controller 150 can selectively permit or direct flow of the primary cooling fluid through the buffer tank 140, such as to absorb heat from the primary loop 110 and/or the primary cooling fluid. In at least one embodiment, the controller 150 can selectively permit or direct flow of the primary cooling fluid through the buffer tank 140, such as upon detection of a high return fluid temperature, a cooling demand exceeding a rated heat transfer capacity of the fluid-to-fluid heat exchanger 130, a power outage, or any combination thereof. In at least one embodiment, the controller 150 can selectively prevent flow of the primary cooling fluid through the buffer tank 140, such as to allow the fluid-to-fluid heat exchanger 130 to transfer heat to the secondary cooling fluid during normal operations.

In at least one embodiment, the controller 150 can open and/or close the inlet valve 172 and the outlet valve 174 together. In at least one embodiment, the controller 150 can fully open and/or close the inlet valve 172 and throttle flow of the primary cooling fluid through the buffer tank 140 using the outlet valve 174. In at least one embodiment, the controller 150 can fully open and/or close the outlet valve 174 and throttle flow of the primary cooling fluid through the buffer tank 140 using the inlet valve 172. In at least one embodiment, the controller 150 can open and/or close the inlet valve 172 and/or the outlet valve 174 inversely proportionally to the control valve 170 (see, e.g., FIG. 4). In at least one embodiment, the controller 150 can begin to open the inlet valve 172 and/or the outlet valve 174, and can begin to close the control valve 170, as the return temperature, or the temperature of the primary cooling fluid exiting the heat load 112, approaches, meets, or exceeds a desired temperature or temperature range (such as from 35 to 36 degrees Celsius, for instance). In at least one embodiment, the controller 150 can fully open the inlet valve 172 and/or the outlet valve 174, and fully close the control valve 170, as the return temperature approaches, meets, or exceeds a desired temperature or temperature range (such as 39 degrees Celsius, for example).

In at least one embodiment, an inlet valve 176 can be fluidically coupled between the secondary loop 120 and the buffer tank 140, and/or an outlet valve 178 can be fluidically coupled between the buffer tank 140 and the secondary loop 120. In at least one embodiment, an inlet valve 176 can be fluidically coupled between the rejection heat exchanger 122 and the buffer tank 140. In at least one embodiment, an inlet valve 176 can be fluidically coupled between the fluid-to-fluid heat exchanger 130 and the buffer tank 140. In at least one embodiment, an outlet valve 178 can be fluidically coupled between the buffer tank 140 and the rejection heat exchanger 122. In at least one embodiment, an outlet valve 178 can be fluidically coupled between the buffer tank 140 and the fluid-to-fluid heat exchanger 130.

In at least one embodiment, the inlet valve 176 and/or the outlet valve 178 can control flow of the secondary cooling fluid through the buffer tank 140. In at least one embodiment, the controller 150 can open and/or close the inlet valve 176 and the outlet valve 178 together, such as simultaneously (i.e., at least about simultaneously). In at least one embodiment, the controller 150 can fully open and/or close the inlet valve 176 and throttle flow of the secondary cooling fluid through the buffer tank 140 using the outlet valve 178. In at least one embodiment, the controller 150 can fully open and/or close the outlet valve 178 and throttle flow of the secondary cooling fluid through the buffer tank 140 using the inlet valve 176. In at least one embodiment, the controller 150 can maintain the inlet valve 176 and/or the outlet valve 178 in at least partially open positions, which can allow the secondary cooling fluid to continuously flow through the buffer tank 140, such as to continuously monitor a temperature of the secondary cooling fluid exiting the buffer tank 140. In at least one embodiment, the controller 150 can begin to open, or further open, the inlet valve 176 and/or the outlet valve 178, as the temperature of the secondary cooling fluid exiting the buffer tank 140 approaches, meets, or exceeds a desired temperature or temperature range for a given implementation of the disclosure (e.g., from 22 to 23 degrees Celsius). In at least one embodiment, the controller 150 can fully open the inlet valve 176 and/or the outlet valve 178, as the temperature of the secondary cooling fluid exiting the buffer tank 140 approaches, meets, or exceeds a desired temperature or temperature range for a given implementation of the disclosure, such as at least about 26 degrees Celsius, for example (see, e.g., FIG. 3).

In at least one embodiment, the controller 150 can monitor a temperature of the secondary cooling fluid exiting the buffer tank 140 and/or control a flow rate of the secondary cooling fluid through the buffer tank 140 using the inlet valve 176 and/or the outlet valve 178. In at least one embodiment, the controller 150 can maintain the flow rate of the secondary cooling fluid through the buffer tank 140 at or above zero, and/or can prevent the flow rate from dropping to or below zero, such as to continuously monitor the temperature of the secondary cooling fluid exiting the buffer tank 140 and/or a temperature (or temperature approximation/surrogate) of one or more contents of the buffer tank 140. In at least one embodiment, the controller 150 can monitor an entry temperature of the secondary cooling fluid entering the buffer tank 140 and an exit temperature of the secondary cooling fluid exiting the buffer tank 140, and determine a temperature (or temperature approximation/surrogate) of the contents of the buffer tank 140.

In at least one embodiment, the buffer tank 140 can contain one or more phase change media 142, such as wax, glycerin, another phase change material, or any combination thereof. In at least one embodiment, the phase change media 142 in the buffer tank 140 can have a thermal mass, which can absorb heat from the primary cooling fluid, such as during fluctuations in cooling demand and/or a power outage. In at least one embodiment, the volume and/or the thermal mass of the phase change media 142 in the buffer tank 140 can be large enough to accommodate expected and/or unexpected fluctuations. In at least one embodiment, the volume and/or the thermal mass of the phase change media 142 in the buffer tank 140 can allow for a relatively smaller cooling system 100 to nonetheless handle the same, or larger, fluctuations, versus a relatively larger conventional cooling system. For example, the system 100, or components thereof, such as one or more pumps, compressors, heat exchangers, or any combination thereof, can be smaller and/or primarily designed to handle normal cooling demand, and the thermal mass of the phase change media 142 in the buffer tank 140 can accommodate abnormal fluctuations, such as by absorbing excess heat from the primary cooling fluid during a fluctuation in cooling demand. In at least one embodiment, the volume and/or the thermal mass of the phase change media 142 in the buffer tank 140 can be arranged for providing adequate time for a backup generator to come online and/or can absorb heat from the primary cooling fluid while a portion of the system 100, such as pumps and/or compressors, are without power before the backup generator comes online. In at least one embodiment, the volume and/or the thermal mass of the phase change media 142 in the buffer tank 140 can be sized according to the expected fluctuations and/or a required time period for one or more backup generators to be brought online and compensate for a loss of primary system power.

In at least one embodiment, the media 142 can be different from the primary cooling fluid and/or the secondary cooling fluid, either or both of which can be or include water, a water-glycol mixture, a refrigerant, another cooling fluid, or any combination thereof. In at least one embodiment, the buffer tank 140 can contain the media 142 therein while the primary cooling fluid and/or the secondary cooling fluid pass through the buffer tank 140 or a portion thereof. In at least one embodiment, the buffer tank 140 can prevent the media 142 from mixing with the primary cooling fluid and/or the secondary cooling fluid as they pass through the buffer tank 140. In at least one embodiment, the media 142 can remain fluidically isolated from, while being thermally coupled to, the primary cooling fluid and/or the secondary cooling fluid, such as via one or more fluidically separate channels or flow paths in or through the buffer tank 140.

In at least one embodiment, the buffer tank 140 can include one or more tubular pathways and/or coils for the primary cooling fluid and/or the secondary cooling fluid to pass through. In at least one embodiment, the buffer tank 140 can include one or more tubular pathways and/or coils 144 for the primary cooling fluid to pass through. In at least one embodiment, the buffer tank 140 can include one or more tubular pathways and/or coils 146 for the secondary cooling fluid to pass through. In at least one embodiment, the coils 144, 146 can provide for thermal coupling of the media 142 with the primary cooling fluid and/or the secondary cooling fluid and for physical and/or fluidic isolation between the media 142 and the primary cooling fluid and/or the secondary cooling fluid. For instance, the media 142 and the primary cooling fluid and/or the secondary cooling fluid can be in thermal communication through or via one or more walls of the coils 144, 146 within the buffer tank 140.

In at least one embodiment, one or both of the tubular pathways and/or coils 144, 146 can be or include one or more heat exchangers 154, 156 disposed within the buffer tank 140 for increasing the heat transfer area and supporting heat transfer among one or more cooling fluids and the media 142. For example, in at least one embodiment, any or all of the heat exchangers 154, 156 can be or include one or more roll bond evaporators, such as a plurality of roll bond evaporators connected in series with one another (see, e.g., FIG. 2).

In at least one embodiment, the system 100 can utilize both the sensible and latent heat characteristics of the media 142 in the buffer tank 140 to absorb heat from the primary cooling fluid. In at least one embodiment, the media 142 in the buffer tank 140 can increase in temperature, while absorbing heat from the primary cooling fluid, using the latent heat of the media 142. In at least one embodiment, the media 142 in the buffer tank 140 can change from a solid phase to a liquid phase, while absorbing heat from the primary cooling fluid, using the latent heat of the media 142. In at least one embodiment, the media 142 in the buffer tank 140 can decrease in temperature and/or change from a liquid phase to a solid phase while transferring heat to the secondary cooling fluid. In at least one embodiment, volumetric and/or pressure changes of the phase change media 142, in transitioning between the solid phase and the liquid phase, can be negligible. In at least one embodiment, pressure and/or other forces exerted on the buffer tank 140 by the phase change media 142, in transitioning between the solid phase and the liquid phase, can be negligible.

In at least one embodiment, a method 200 according to the disclosure, such as a method of operating or controlling a cooling system, can include, such as for pre-startup and/or any time a temperature of the media 142 in the buffer tank 140 exceeds a threshold, cooling the media 142 in the buffer tank 140, such as via the secondary cooling fluid flowing through the buffer tank 140, as illustrated in FIG. 3, for example. In at least one embodiment, a method 200 can include, such as for normal operations, transferring heat from the heat load 112 to the primary cooling fluid, from the primary cooling fluid to the secondary cooling fluid, such as through the fluid-to-fluid heat exchanger 130, and then rejecting the heat from the secondary cooling fluid, such as through the rejection heat exchanger 122. In at least one embodiment, a method 200 according to the disclosure can include, such as for abnormal operations (e.g., an elevated return temperature, a cooling demand exceeding the rated heat transfer capacity of the fluid-to-fluid heat exchanger 130, a power outage, etc.), transferring heat from the heat load 112 to the primary cooling fluid, from the primary cooling fluid to the media 142 in the buffer tank 140 and to the secondary cooling fluid through the fluid-to-fluid heat exchanger 130 and/or buffer tank 140, and rejecting the heat from the secondary cooling fluid, such as through the rejection heat exchanger 122.

In at least one embodiment, a method 200 according to the disclosure can include extracting heat from a heat load 112, such as by circulating a primary cooling fluid through or otherwise in thermal communication with the heat load 112, as shown in step 210, for example. In at least one embodiment, a method 200 according to the disclosure can include transferring heat from the primary cooling fluid to a secondary cooling fluid, as shown in step 220, and/or rejecting heat from the secondary cooling fluid, as shown in step 230. In at least one embodiment, a method 200 according to the disclosure can include monitoring a temperature of the primary cooling fluid exiting the heat load 112, as shown in step 240, and/or absorbing a portion of the heat within a phase change media 142, such as when the temperature exceeds a threshold, as shown in step 250. In at least one embodiment, a method 200 according to the disclosure can include cooling the phase change media 142, such as by circulating a secondary cooling fluid through the buffer tank 140, as shown in step 260. In at least one embodiment, heat transferred to the secondary cooling fluid from the phase change media 142 in the buffer tank 140 can also be rejected, as shown in step 230.

In at least one embodiment, absorbing a portion of the heat within a phase change media 142 can include directing a portion of the primary cooling fluid through a buffer tank 140 containing the phase change media 142. In at least one embodiment, transferring the heat from the primary cooling fluid to the secondary cooling fluid can be done through a fluid-to-fluid heat exchanger 130 fluidically coupled in parallel with the buffer tank 140 with respect to the secondary cooling fluid and/or fluidically coupled in series with the buffer tank 140 with respect to the primary cooling fluid.

In at least one embodiment, a cooling system according to the disclosure can include a primary loop for circulating a primary cooling fluid, a secondary loop for circulating a secondary cooling fluid, one or more fluid-to-fluid heat exchangers fluidically coupled to the primary loop and/or the secondary loop, one or more buffer tanks fluidically coupled to the primary loop and/or the secondary loop, or any combination thereof. In at least one embodiment, the primary loop can extract heat from one or more heat loads via the primary cooling fluid. In at least one embodiment, the secondary loop can reject heat from one or more heat loads via the secondary cooling fluid. In at least one embodiment, the fluid-to-fluid heat exchanger can transfer heat from the primary cooling fluid to the secondary cooling fluid. In at least one embodiment, the buffer tank can selectively absorb heat from the primary loop and/or selectively transfer heat to the secondary loop. In at least one embodiment, the fluid-to-fluid heat exchanger can be fluidically coupled in parallel with the buffer tank with respect to the secondary cooling fluid. In at least one embodiment, the fluid-to-fluid heat exchanger can be fluidically coupled in series with the buffer tank with respect to the primary cooling fluid.

In at least one embodiment, the buffer tank can be plumbed in parallel with a control valve in the primary loop. In at least one embodiment, an inlet valve can be fluidically coupled between the heat load and the buffer tank. In at least one embodiment, an outlet valve can be fluidically coupled between the buffer tank and the fluid-to-fluid heat exchanger. In at least one embodiment, the inlet valve and/or the outlet valve can control flow of the primary cooling fluid through the buffer tank.

In at least one embodiment, a cooling system according to the disclosure can include a controller for monitoring a temperature of the primary cooling fluid exiting the heat load and/or selectively directing, such as according to a temperature, a portion of the primary cooling fluid through the buffer tank using the control valve, the inlet valve, the outlet valve, or any combination thereof. In at least one embodiment, the controller can selectively prevent flow of the primary cooling fluid through the buffer tank, such as to allow the fluid-to-fluid heat exchanger to transfer the heat to the secondary cooling fluid, and/or selectively permit flow of the primary cooling fluid through the buffer tank, such as to absorb heat from the primary loop and/or primary cooling fluid. In at least one embodiment, the controller can open and/or close the inlet valve and the outlet valve together. In at least one embodiment, the controller can open and/or close the inlet valve and/or the outlet valve inversely proportionally to the control valve.

In at least one embodiment, a cooling system according to the disclosure can include an inlet valve fluidically coupled between the secondary loop and the buffer tank and/or an outlet valve fluidically coupled between the buffer tank and the secondary loop. In at least one embodiment, the inlet valve and/or the outlet valve can control flow of the secondary cooling fluid through the buffer tank. In at least one embodiment, the cooling system can include one or more controllers for monitoring a temperature of the secondary cooling fluid exiting the buffer tank and/or controlling a flow rate of the secondary cooling fluid through the buffer tank using the inlet valve and the outlet valve, such as in cooperation with one or more sensors and/or flow control components. In at least one embodiment, the controller can maintain the flow rate of the secondary cooling fluid through the buffer tank above zero and/or prevent the flow rate from dropping to zero, which can provide for continuous monitoring of a temperature of the secondary cooling fluid exiting the buffer tank and/or a temperature (or temperature approximation/surrogate) of the contents of the buffer tank.

In at least one embodiment, the buffer tank can contain a phase change media, such as wax and/or glycerin, and/or one or more other media. In at least one embodiment, the phase change media can be different from the primary cooling fluid and/or the secondary cooling fluid, either or both of which can be or include water, a water-glycol mixture, a refrigerant, another cooling fluid, or any combination thereof. In at least one embodiment, the buffer tank can contain the media therein while the primary cooling fluid and/or the secondary cooling fluid pass therethrough. In at least one embodiment, the buffer tank can prevent one or more media therein from mixing with the primary cooling fluid and/or the secondary cooling fluid as the primary cooling fluid and/or the secondary cooling fluid flow therethrough. In at least one embodiment, the phase change media can remain fluidically isolated from, yet thermally coupled to, the primary cooling fluid and/or the secondary cooling fluid, such as via one or ore more coils or other fluid conduits.

In at least one embodiment, the phase change media in the buffer tank can change from a solid phase to a liquid phase while absorbing heat from the primary cooling fluid and/or can change from a liquid phase to a solid phase while transferring heat to the secondary cooling fluid. In at least one embodiment, volumetric and/or pressure changes of the phase change media, in transitioning between the solid phase and the liquid phase, can be negligible. In at least one embodiment, pressure and/or other forces exerted on the buffer tank by the phase change media, in transitioning between the solid phase and the liquid phase, can be negligible.

In at least one embodiment, a method of operating a cooling system according to the disclosure can include extracting heat from a heat load, such as by circulating a primary cooling fluid through the heat load, transferring heat from the primary cooling fluid to a secondary cooling fluid, rejecting heat from the secondary cooling fluid, monitoring a temperature of the primary cooling fluid exiting the heat load, absorbing a portion of the heat within a phase change media, such as when the temperature exceeds a threshold, cooling the phase change media by circulating a secondary cooling fluid through the buffer tank, or any combination thereof. In at least one embodiment, absorbing a portion of the heat within a phase change media can include directing a portion of the primary cooling fluid through a buffer tank containing the phase change media. In at least one embodiment, transferring the heat from the primary cooling fluid to the secondary cooling fluid can be done through a fluid-to-fluid heat exchanger fluidically coupled in parallel with the buffer tank with respect to the secondary cooling fluid and/or fluidically coupled in series with the buffer tank with respect to the primary cooling fluid.

Other and further embodiments utilizing one or more aspects of the disclosure can be devised without departing from the Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.

The disclosure comprises the following items:
1. A cooling system comprising:
   a primary loop configured to extract heat from a heat load via a primary cooling fluid;
   a secondary loop configured to reject the heat from the heat load via a secondary cooling fluid;
   a fluid-to-fluid heat exchanger fluidically coupled to the primary loop and the secondary loop and configured to transfer the heat from the primary cooling fluid to the secondary cooling fluid; and
   a buffer tank fluidically coupled to the primary loop and the secondary loop, wherein the buffer tank is configured to selectively absorb heat from the primary loop and selectively transfer heat to the secondary loop.
2. The cooling system as set forth in item 1, wherein the buffer tank is plumbed in parallel with a control valve in the primary loop.
3. The cooling system as set forth in item 1 or item 2, further comprising an inlet valve fluidically coupled between the heat load and the buffer tank and an outlet valve fluidically coupled between the buffer tank and the fluid-to-fluid heat exchanger, wherein the inlet valve and the outlet valve are configured to control flow of the primary cooling fluid through the buffer tank.
4. The cooling system as set forth in any preceding item, further comprising a controller configured to monitor a temperature of the primary cooling fluid exiting the heat load and selectively direct, according to the temperature, a portion of the primary cooling fluid through the buffer tank using the control valve, the inlet valve, and the outlet valve.
5. The cooling system as set forth in any preceding item, wherein the controller is configured to selectively prevent flow of the primary cooling fluid through the buffer tank and selectively permit flow of the primary cooling fluid through the buffer tank to absorb heat from the primary loop.
6. The cooling system as set forth in any preceding item, wherein the controller is configured to open and close the inlet valve and the outlet valve together and inversely proportionally to the control valve.
7. The cooling system as set forth in any preceding item, further comprising an inlet valve fluidically coupled between the secondary loop and the buffer tank and an outlet valve fluidically coupled between the buffer tank and the secondary loop, wherein the inlet valve and the outlet valve are configured to control flow of the secondary cooling fluid through the buffer tank.
8. The cooling system as set forth in any preceding item, further comprising a controller configured to monitor a temperature of the secondary cooling fluid exiting the buffer tank and control a flow rate of the secondary cooling fluid through the buffer tank using the inlet valve and the outlet valve.
9. The cooling system as set forth in any preceding item, wherein the controller is configured to prevent the flow rate from dropping to zero.
10. The cooling system as set forth in any preceding item, wherein the buffer tank contains a phase change media.
11. The cooling system as set forth in any preceding item, wherein the phase change media is different than the primary cooling fluid and the secondary cooling fluid.
12. The cooling system as set forth in any preceding item, wherein the phase change media is fluidically isolated from, and thermally coupled to, the primary cooling fluid and the secondary cooling fluid.
13. The cooling system as set forth in any preceding item, wherein the buffer tank is configured to contain the phase change media therein while the primary cooling fluid and the secondary cooling fluid pass through the buffer tank.
14. The cooling system as set forth in any preceding item, wherein the phase change media in the buffer tank is configured to change from a solid phase to a liquid phase while absorbing heat from the primary cooling fluid.
15. The cooling system as set forth in any preceding item, wherein the phase change media in the buffer tank is configured to change from a liquid phase to a solid phase while transferring heat to the secondary cooling fluid.
16. The cooling system as set forth in any preceding item, wherein the buffer tank contains a media that is different than the primary cooling fluid and the secondary cooling fluid.
17. The cooling system as set forth in any preceding item, wherein the media is fluidically isolated from, but thermally coupled to, the primary cooling fluid and the secondary cooling fluid; and wherein the buffer tank is configured to contain the media within the buffer tank while the primary cooling fluid and the secondary cooling fluid pass through the buffer tank.
18. The cooling system as set forth in any preceding item, wherein the fluid-to-fluid heat exchanger is fluidically coupled in parallel with the buffer tank with respect to the secondary cooling fluid; and wherein the fluid-to-fluid heat exchanger is fluidically coupled in series with the buffer tank with respect to the primary cooling fluid.

## Claims

1. A cooling system comprising:
a primary loop configured to extract heat from a heat load via a primary cooling fluid;
a secondary loop configured to reject the heat from the heat load via a secondary cooling fluid;
a fluid-to-fluid heat exchanger fluidically coupled to the primary loop and the secondary loop and configured to transfer the heat from the primary cooling fluid to the secondary cooling fluid; and
a buffer tank fluidically coupled to the primary loop and the secondary loop, wherein the buffer tank is configured to selectively absorb heat from the primary loop and selectively transfer heat to the secondary loop.

2. The cooling system as set forth in claim 1, wherein the buffer tank is plumbed in parallel with a control valve in the primary loop.

3. The cooling system as set forth in claim 2, further comprising an inlet valve fluidically coupled between the heat load and the buffer tank and an outlet valve fluidically coupled between the buffer tank and the fluid-to-fluid heat exchanger, wherein the inlet valve and the outlet valve are configured to control flow of the primary cooling fluid through the buffer tank.

4. The cooling system as set forth in claim 3, further comprising a controller configured to monitor a temperature of the primary cooling fluid exiting the heat load and selectively direct, according to the temperature, a portion of the primary cooling fluid through the buffer tank using the control valve, the inlet valve, and the outlet valve.

5. The cooling system as set forth in claim 4, wherein the controller is configured to selectively prevent flow of the primary cooling fluid through the buffer tank and selectively permit flow of the primary cooling fluid through the buffer tank to absorb heat from the primary loop.

6. The cooling system as set forth in claim 4 or claim 5, wherein the controller is configured to open and close the inlet valve and the outlet valve together and inversely proportionally to the control valve.

7. The cooling system as set forth in claim 1, further comprising an inlet valve fluidically coupled between the secondary loop and the buffer tank and an outlet valve fluidically coupled between the buffer tank and the secondary loop, wherein the inlet valve and the outlet valve are configured to control flow of the secondary cooling fluid through the buffer tank.

8. The cooling system as set forth in claim 7, further comprising a controller configured to monitor a temperature of the secondary cooling fluid exiting the buffer tank and control a flow rate of the secondary cooling fluid through the buffer tank using the inlet valve and the outlet valve, and optionally wherein the controller is configured to prevent the flow rate from dropping to zero.

9. The cooling system as set forth in any preceding claim, wherein the buffer tank contains a phase change media.

10. The cooling system as set forth in claim 9, wherein the phase change media is different than the primary cooling fluid and the secondary cooling fluid.

11. The cooling system as set forth in claim 9 or claim 10, wherein the phase change media is fluidically isolated from, and thermally coupled to, the primary cooling fluid and the secondary cooling fluid.

12. The cooling system as set forth in any of claims 9-11, wherein the buffer tank is configured to contain the phase change media therein while the primary cooling fluid and the secondary cooling fluid pass through the buffer tank.

13. The cooling system as set forth in any of claims 10-12, wherein the phase change media in the buffer tank is configured to change from a solid phase to a liquid phase while absorbing heat from the primary cooling fluid, and/or wherein the phase change media in the buffer tank is configured to change from a liquid phase to a solid phase while transferring heat to the secondary cooling fluid.

14. The cooling system as set forth in claim 1, wherein the buffer tank contains a media that is different than the primary cooling fluid and the secondary cooling fluid, and optionally wherein:
the media is fluidically isolated from, but thermally coupled to, the primary cooling fluid and the secondary cooling fluid; and wherein the buffer tank is configured to contain the media within the buffer tank while the primary cooling fluid and the secondary cooling fluid pass through the buffer tank.

15. The cooling system as set forth in any preceding claim, wherein the fluid-to-fluid heat exchanger is fluidically coupled in parallel with the buffer tank with respect to the secondary cooling fluid; and wherein the fluid-to-fluid heat exchanger is fluidically coupled in series with the buffer tank with respect to the primary cooling fluid.
